# EUROPEAN PATENT APPLICATION

(11) **EP 3 208 363 A1**
(43) Date of publication of application: **23.08.2017**
(21) Application number: 15850658.4
(22) Date of filing: 13.10.2015
(51) Int. Cl.: C23C 14/34, C23C 14/56, C23C 16/455, C23C 16/54, H01L 21/316

(54) **METHOD FOR FORMING FILM ON FLEXIBLE SUBSTRATE USING VAPOR PHASE DEPOSITION METHOD**

(30) Priority: 14.10.2014 JP 2014210299
(71) Applicant: Toppan Printing Co., Ltd., Tokyo 110-0016 (JP)
(72) Inventor: KON, Masato, Tokyo 110-0016 (JP)
(74) Representative: Hoffmann Eitle
(86) International application number: PCT/JP2015/005176
(87) International publication number: WO 2016/059789

(57) **Abstract**

A method for forming a film on a flexible substrate by vapor deposition is provided, wherein the method is capable of reducing in size of the entire apparatus and improving an efficiency to thereby enhance productivity. A film formation method includes the steps of: transporting the flexible substrate through a first zone in a vacuum chamber, into which a raw material gas containing metal or silicon is introduced, so that components included in the raw material gas are adsorbed onto the flexible substrate, and performing sputter deposition by transporting the flexible substrate through a second zone in the vacuum chamber, the second zone being separated from the first zone and including a target material containing metal or silicon.

## Description

### [Technical Field]

The present invention relates to a film formation method for forming a thin film on a flexible substrate. More specifically, the present invention relates to a vacuum film formation method for forming a thin film on a flexible substrate by means of gas phase deposition while continuously or discontinuously transporting the flexible substrate.

### [Background Art]

Methods for forming a thin film by means of gas phase deposition can be broadly divided into chemical vapor deposition (CVD) and physical vapor deposition (PVD).

PVD typically includes vacuum vapor deposition and sputter deposition. In particular, sputter deposition enables production of a high quality thin film with uniform film properties and film thickness, although the apparatus cost is usually high. Sputter deposition is widely applied to display devices and the like. However, the film may have defects.

CVD is a process of growing a solid thin film by introducing a raw material gas into a vacuum chamber, and decomposing or reacting one type or two or more types of gas on a substrate by means of heat energy. In some cases, plasma or catalyst reaction may also be used in combination to promote the reaction during film formation or to decrease the reaction temperature. CVD using plasma is called plasma enhanced CVD (PECVD), and CVD using catalyst reaction is called catalytic CVD (Cat-CVD). Although chemical vapor deposition is characterized by having fewer defects in film formation and is mainly applied to production of semiconductor devices such as film formation of a gate insulation film, it has a disadvantage in that a relatively high temperature is required for film formation.

Atomic layer deposition (ALD) is a film formation process in which a film is formed in a layer-by-layer manner at an atomic level by chemically reacting the substances which are adsorbed on the surface, and is classified as CVD. ALD is distinguished from general CVD in that general CVD uses a single gas or concurrently uses a plurality of gases which are reacted on a substrate to thereby grow a thin film on a substrate, while ALD is a particular film formation method which uses a highly reactive gas, which is referred to as a precursor, and another reactive gas (which is also referred to as a precursor) to perform adsorption on the substrate surface and the subsequent chemical reactions to thereby grow a thin film in a layer-by-layer manner at an atomic level.

Specifically, by using a self-limiting effect in surface adsorption that prohibits a certain type of gas from being adsorbed onto a surface after the surface is covered by the gas, only one layer of precursor is adsorbed onto the surface and unreacted precursor is purged. Then, another reactive gas is introduced to oxidize or reduce the above precursor to thereby obtain one layer of a thin film having a desired composition. After that, the reactive gas is purged. This cycle is repeated so as to grow a thin film in a layer-by-layer manner. Accordingly, a thin film grows in two dimensions in the ALD process. ALD is characterized by reducing deficiencies in film formation compared with the typical CVD as well as the conventional vapor deposition or sputtering, and is expected to be applied to various fields.

ALD may include a process of using plasma to enhance reaction in the step of decomposing a second precursor and reacting the decomposed second precursor with a first precursor adsorbed on the substrate, which is called plasma enhanced ALD (PEALD) or simply plasma ALD.

Since ALD is characterized by having no projection effect or the like compared with other film formation methods, film formation can be performed only if there is a gap through which a gas is introduced. Accordingly, ALD is expected to be applied to fields related to micro electro mechanical systems (MEMS) for covering a three-dimensional structure, as well as for covering lines and holes having a high aspect ratio.

By using the aforementioned film formation method, a thin film is formed on a variety of targets including a small plate-shaped substrate such as a wafer or photomask, a substrate having a large surface area and no flexibility such as a glass plate, or a substrate having a large surface area and flexibility such as a film, and the like. Accordingly, for mass production facilities that form a thin film on these substrates, a variety of handling methods for the substrates which are different in cost, easiness of handling, film formation quality, and the like have been proposed and put into a practical use.

For example, there are sheet type deposition, batch type deposition, and the like. In sheet type deposition, film formation is performed while one sheet of substrate is supplied on a wafer in a film formation apparatus, and then, film formation is again performed after the sheet is replaced with a subsequent substrate. In batch type deposition, a plurality of substrates are collectively set so that the same film formation is performed onto all the wafers.

Further, methods for forming a film on a glass substrate or the like include an in-line method, in which film formation is concurrently performed while a substrate is successively transported to a portion of a deposition source, and a web coating method using a so-called roll-to-roll method, in which film formation is performed mainly on a flexible substrate while the substrate is paid out from a roll and transported, and then the substrate is taken up by another roll. The web-coating method also includes a transportation/continuous film formation process, in which a substrate on which a film is formed, as well as the flexible substrate, is continuously transported on a flexible sheet or on a partially flexible tray.

An optimal combination is adopted from the above film formation methods and the handling methods for the substrates, considering the cost, quality, easiness of handling, and the like.

ALD has disadvantages such as use of a specific material and its cost. Among others, since ALD is a process which grows a thin film at an atomic level by depositing a layer in each cycle, the most significant disadvantage is that the film formation speed is 5 to 10 times slower than other film formation methods such as vapor deposition and sputtering.

To solve the above problem, contrary to the conventional process in which a precursor is repeatedly supplied and discharged in a single chamber (which is called a time-divided type), a space-divided type has been proposed, in which the chamber is divided into several zones (areas) so that a single precursor or purge gas is supplied into the respective zones while the substrate is reciprocated among the zones (for example, see PTL 1).

### [Citation List]

### [Patent Literature]

[PTL 1] WO2007/112370

### [Summary of the Invention]

### [Technical Problem]

Emergence of the space-divided type ALD process has significantly improved the film formation speed. However, the film formation speed is not sufficiently improved compared with CVD or sputter deposition, and this contributes to an increase in film formation cost. In a roll-to-roll ALD process, the film formation speed is determined depending on a transport speed of the flexible material when the ideal film formation conditions such as saturated adsorption being accomplished are met. In order to increase the film thickness, there is a need for increase the area in which the substrate reciprocates at least between two zones, that is, increase the size of apparatus, which also contributes to increase in the cost. Further, to increase durability of the film produced, a film thickness of a certain extent is required.

To improve a film formation speed, atomic vapor deposition (AVD) has been proposed, in which a precursor is introduced in a pulsed manner while a reactive gas is constantly supplied. However, this process is directed to a batch type film formation apparatus of a time-divided type, and is not suitable for use in a roll-to-roll film formation of a time-divided type.

An object of the present invention is to provide a film formation method for forming a thin film on a flexible substrate, wherein the film formation method is capable of reducing the size of the entire apparatus and improving an efficiency to thereby enhance productivity.

### [Solution to Problem]

An aspect of the present invention that solves the above problem is a film formation method for forming a thin film on a flexible substrate, the method including the steps of: transporting the flexible substrate through a first zone in a vacuum chamber, into which a raw material gas containing metal or silicon is introduced, so that components included in the raw material gas are adsorbed onto the flexible substrate, and performing sputter deposition by transporting the flexible substrate through a second zone in the vacuum chamber, the second zone being separated from the first zone and including a target material containing metal or silicon.

The method may further include a step of transporting the flexible substrate through a third zone into which an inert gas is introduced between the steps of transporting the flexible substrate through the first zone and transporting the flexible substrate through the second zone.

Further, a component of metal contained in the raw material gas may be the same as a component of metal contained in the target material.

Further, a component of metal contained in the raw material gas may be different from a component of metal contained in the target material.

Further, the target material may include silicon.

Further, the second zone may include a plurality of the target materials, and at least two of the target materials may be different in the components of materials included or different in percentages of the components.

Further, film formation may be performed by reactive sputtering in the second zone.

Further, a film thickness of a sputter film formed after the flexible substrate passes through the second zone once may be 0.2 nm or more.

### [Advantageous Effects of Invention]

According to a film formation method of the present invention, a high quality film can be obtained with a film formation speed higher than that of sputter deposition. Therefore, a film formation method having high productivity can be provided. Moreover, the apparatus can be reduced in size. Further, occurrence of film formation defects specific to sputter deposition on a film can be reduced.

### [Brief Description of the Drawings]

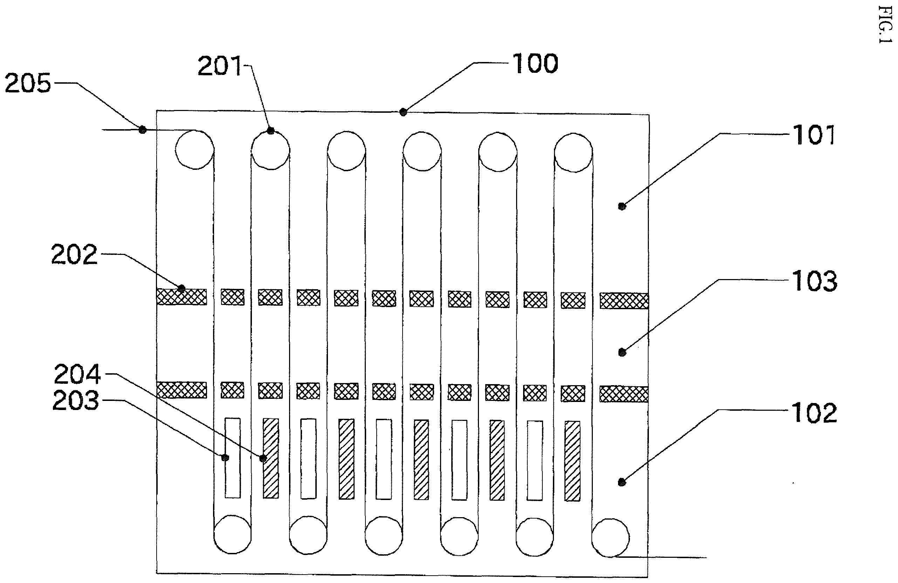

Fig. 1 is a schematic cross-sectional view of a vacuum chamber that enables a film formation method according to an embodiment of the present invention.

### [Description of Embodiments]

A film formation method according to the present invention is a method for forming a thin film on a flexible substrate, the method including the steps of: transporting the flexible substrate through a first zone in a vacuum chamber, into which a raw material gas containing metal or silicon is introduced, so that components included in the raw material gas are adsorbed onto the flexible substrate, and performing sputter deposition by transporting the flexible substrate through a second zone in the vacuum chamber, the second zone being separated from the first zone and including a target material containing metal or silicon.

In the step of transporting the flexible substrate through the first zone, the raw material gas containing metal or silicon covers the entire surface of the flexible substrate in a three dimensional manner, including holes and pits present on the flexible substrate. In the subsequent step of transporting the flexible substrate through the second zone, a thin film containing components which constitute the sputtering target is expected to be formed by sputter deposition. Accordingly, deposition for a film thickness from a few atomic layers to a few tens or a few hundreds of atomic layers is expected depending on the sputter deposition conditions. By repeating these steps, a film thickness corresponding to one atomic layer level is achieved in the first zone, and a film thickness corresponding to the sputter deposition is achieved in the second zone. Although sputter deposition is a process having many defects, the raw material gas in the first zone covers the defects, if any, to thereby form a generally good thin film. The above may be applied to a dielectric film, gas barrier film and the like.

In addition, the method may further include a step of transporting the flexible substrate through a third zone into which an inert gas is introduced between the steps of transporting the flexible substrate through the first zone and transporting the flexible substrate through the second zone. This can prevent gases in the first zone and the second zone from being mixed and avoid unintentional film deposition onto an inner wall of the chamber and onto the flexible substrate.

In addition, a thin film of a single material can be produced when the components of metal contained in the raw material gas are the same as the components of metal contained in the target material.

On the other hand, a mixture thin film or a composite thin film containing a plurality of metals may be produced when the components of metal contained in the raw material gas are different from the components of metal contained in the target material. Further, the term "components of metal" refers not only to the components contained in the raw material gas and the target material, but also the components of main metal (such as atomic ratio and weight ratio).

These can be selected depending on the application of a thin film.

Further, when the target material includes silicon, a silicon-containing thin film can be produced in the step of sputter deposition without using an expensive silicon-containing raw material gas.

In addition, when the second zone includes a plurality of target materials with different material properties included or different component ratio of the material properties included, a thin film can be produced with a variety of compositions.

In addition, when reactive sputtering is used as a sputter deposition, an inexpensive non-oxide target such as metal can be used.

In addition, when the film thickness of the sputter film formed after the flexible substrate passes through the second zone once is determined as 0.2 nm or more, the film formation speed can be effectively improved.

With reference to Fig. 1, an embodiment of the present invention will be described in detail. Fig. 1 is a schematic cross-sectional view of a vacuum chamber that enables a film formation method according to an embodiment of the present invention.

A vacuum chamber 100 can be separated into at least three zones by partitions 202. A flexible substrate 205 reciprocates among the respective zones. A raw material gas is introduced into a first zone 101. Sputtering targets 203 are disposed in a second zone 102 so that the target material is set corresponding to the film type of the target of film formation. The sputtering targets 203 may be the same material type or may have the same composition ratio. Alternatively, only one or a plurality of the sputtering targets 203 or each sputtering target 203 may be different from each other. As seen from the figure, when other sputtering targets 204 are disposed between the plurality of sputtering targets 203 so that the sputtering targets 203 and 204 are located on both sides of the flexible substrate 205, film formation can be performed on both surfaces. When different materials are used for the sputtering targets 203 and the sputtering targets 204, thin films of different material can be formed on one and the other surfaces of the flexible substrate 205.

Here, when the main component of the metal or silicon mainly contained in the raw material gas is the same as the main component of the metal or silicon mainly contained in the sputtering target, a thin film of the same (a single) component can be formed. However, when they are different from each other, a thin film of a plurality of components can be formed. Of the components which constitute the film, when the components of sputter deposition accounts for a large portion and the components of the raw material gas adsorbed in the first zone 101 accounts for a small portion, the components of the raw material gas may also be used as a doping material for the sputter film.

The flexible substrate 205 is set in the vacuum chamber 100 in the film formation apparatus, and make a vacuum in the chamber. Since the required degree of vacuum varies depending on the film properties or allowable processing speed in film formation, it should not be unambiguously determined. The material for the flexible substrate 205 may be PET (polyethylene terephthalate), PEN (polyethylene naphthalate), polyimide or the like, or any other material including a foil, paper, and cloth that can bear the transport of the substrate in the apparatus configuration. The material may also be silicon or glass which is thinned and curved. A composite material containing the above material can also be used.

If necessary, the vacuum chamber 100 is heated as appropriate.

Subsequently, a raw material gas containing metal or silicon is introduced into the first zone 101, and argon gas is introduced into the second zone 102. In the case where reactive sputtering is performed in the second zone 102, a reactive gas such as oxygen is also introduced. During this operation, cleaning on the target surface by pre-sputtering is also performed.

An inert argon or nitrogen gas may be introduced as a purge gas into the third zone 103. Here, a gas pressure of the third zone 103 may be set to be the highest among those of the other zones. Accordingly, the probability or percentage of mixture of the precursor introduced into the first zone 101 and the precursor introduced into the second zone 102 can be reduced. However, this does not apply to a case where a component inactive to the raw material gas introduced into the first zone 101 is selected as a gas for sputtering.

Then, sputter deposition is performed along with the start of transportation of the flexible substrate 205. Although general DC sputtering can be used, radio frequency waves, microwaves, an inductively coupled plasma (ICP), and the like can also be used as a plasma excitation source depending on the number of cathodes (targets). Known techniques may also be applied to prevent arcing. Examples of these techniques include use of a pulsed DC power supply and use of a DC power supply with an arc-cut control circuit.

The power applied to plasma during sputter deposition can be freely set depending on desired film properties and film formation speed. In sputter deposition, the film thickness of the produced film generally increases in proportion to discharge power. By appropriately setting the film thickness, adsorption of the raw material gas and sputter deposition can be appropriately repeated in a complementary and alternative manner.

The flexible substrate 205 reciprocates between the first zone 101 and the second zone 102 until a desired film thickness is obtained. Since the transport speed of the substrate is limited by the throughput required and permitted by the film properties, it is not advantageous to use a pre-defined speed.

After the film formation is performed until the desired film thickness is obtained, the plasma is turned off, supply of gases including the raw material gas is stopped, and the vacuum chamber 100 is evacuated to completely discharge the gas remaining in the chamber. After that, the vacuum chamber 100 is vented to remove the flexible substrate 205. In a case where the flexible substrate 205 is paid out and taken up in a roll-to-roll manner by a separate chamber, the separate chamber is vented to remove the roll on which the film is formed.

Thus, the film formation is complete.

### [Industrial Applicability]

The present invention can be used in the process of producing a thin film on a flexible substrate while transporting the flexible substrate.

### [Reference Signs List]

- 100: vacuum chamber
- 101: first zone
- 102: second zone
- 103: third zone
- 201: roller
- 202: zone separator
- 203: sputtering target
- 204: sputtering target
- 205: flexible substrate

## Claims

1. A film formation method for forming a thin film on a flexible substrate, the method comprising the steps of:
transporting the flexible substrate through a first zone in a vacuum chamber, into which a raw material gas containing metal or silicon is introduced, so that components included in the raw material gas are adsorbed onto the flexible substrate, and
performing sputter deposition by transporting the flexible substrate through a second zone in the vacuum chamber, the second zone being separated from the first zone and including a target material containing metal or silicon.

2. The film formation method according to claim 1, further comprising a step of transporting the flexible substrate through a third zone into which an inert gas is introduced between the steps of transporting the flexible substrate through the first zone and transporting the flexible substrate through the second zone.

3. The film formation method according to claim 1 or 2, wherein a component of metal contained in the raw material gas is the same as a component of metal contained in the target material.

4. The film formation method according to claim 1 or 2, wherein a component of metal contained in the raw material gas is different from a component of metal contained in the target material.

5. The film formation method according to claim 1 or 2, wherein the target material includes silicon.

6. The film formation method according to any one of claims 1, 2, and 5, wherein
the second zone includes a plurality of the target materials, and at least two of the target materials are different in the components of materials included or different in percentages of the components.

7. The film formation method according to any one of claims 1 to 6, wherein film formation is performed by reactive sputtering in the second zone.

8. The film formation method according to any one of claims 1 to 7, wherein a film thickness of a sputter film formed after the flexible substrate passes through the second zone once is 0.2 nm or more.
